**Europäisches Patentamt**

**European Patent Office**

**Office européen des brevets**

(19)

(11) Veröffentlichungsnummer: **0 179 828**
**B1**

(12) **EUROPÄISCHE PATENTSCHRIFT**

(45) Veröffentlichungstag der Patentschrift :
19.07.89

(51) Int. Cl.⁴: **H 01 L 31/10, H 01 L 31/02**

(21) Anmeldenummer : 85901983.8

(22) Anmeldetag : 25.04.85

(86) Internationale Anmeldenummer :
PCT/DE 85/00134

(87) Internationale Veröffentlichungsnummer :
WO/8504987 (07.11.85 Gazette 85/24)

(54) GROSSFLÄCHIGER HALBLEITERSTRAHLUNGSDETEKTOR NIEDRIGER KAPAZITÄT.

(30) Priorität : 25.04.84 DE 3415439
05.03.85 DE 3507763

(43) Veröffentlichungstag der Anmeldung :
07.05.86 Patentblatt 86/19

(45) Bekanntmachung des Hinweises auf die Patenterteilung : 19.07.89 Patentblatt 89/29

(84) Benannte Vertragsstaaten :
AT BE CH DE FR GB IT LI LU NL SE

(56) Entgegenhaltungen :
EP--A-- 0 086 928
FR--A-- 1 579 657
US--A-- 3 932 732
US--A-- 4 133 698
IEEE International Electron Devices Meeting, Technical Digest, Washington, D.C. (US), 4-6 December
1978, IEEE 1978, New York (US). R.J. Schwartz et al.:
"The effects of surface potential on surface recombination and the performance of silicon solar cells",
pages 74-77

(73) Patentinhaber : KEMMER, Josef
Hauptstrasse 41 D
D-8048 Haimhausen (DE)

Lutz, Gerhard, Dr.
Therese-Giehse-Allee 23
D-8000 München 83 (DE)

(72) Erfinder : KEMMER, Josef
Hauptstrasse 41 D
D-8048 Haimhausen (DE)
Erfinder : Lutz, Gerhard, Dr.
Therese-Giehse-Allee 23
D-8000 München 83 (DE)

(74) Vertreter : Steinmann, Otto C. et al
Kanzlei Münich, Steinmann, Schiller Willibaldstrasse
36
D-8000 München 21 (DE)

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

### Technisches Gebiet

Die Erfindung bezieht sich auf eine großflächige Halbleiteranordnung niedriger Kapazität gemäß dem Oberbegriff der Patentansprüche 1 bzw. 2.

Eine derartige Halbleiteranordnung ist beispielsweise als großflächiger Strahlungsdetektor für Korpuskular-Strahlung, -Strahlung, Röntgenstrahlung oder Licht mit Wellenlängen vom UV bis Infrarot verwendbar.

### Stand der Technik

Eine Halbleiteranordnung mit niedriger Kapazität gemäß dem Oberbegriff des Patentanspruchs 1 ist beispielsweise aus der Veröffentlichung 33 523 des Brookhaven National Laboratory bekannt. Diese Anordnung erfordert jedoch das Anlegen definierter Potentialgradienten auf beiden Seiten. Durch diese Potentialgradienten wird zum einen der Halbleiterkörper völlig verarmt und zum anderen das notwendige transversale Driftfeld für die Majoritätsträger, also beispielsweise die Elektronen bei n-leitendem Grundkörper erzeugt.

Bei dieser bekannten Halbleiteranordnung niedriger Kapazität werden die Minoritätsträger, also beispielsweise die Löcher, nicht als Informationsquelle benutzt.

Bei großflächigen Anordnungen, beispielsweise bei Anordnungen mit einer empfindlichen Fläche von vielen cm$^2$, ist diese Anordnung wegen der notwendigen Strukturierung und wegen der sehr langen Driftwege der Elektronen, durch die die Zählrate herabgesetzt wird, nicht praktikabel.

### Darstellung der Erfindung

Der Erfindung liegt die Aufgabe zugrunde, eine Halbleiteranordnung gemäß dem Oberbegriff der Patentansprüche 1 bzw. 2 derart weiterzubilden, daß bei weiterhin niedriger Kapazität und mit vergleichsweise geringem technischem Aufwand auch bei großen Flächen kurze Driftzeiten der Elektronen realisierbar sind.

Eine erfindungsgemäße Lösung dieser Aufgabe ist in den Patentansprüchen 1 bzw. 2 angegeben.

Gemäß Anspruch 1 wird der Halbleiterkörper, der beispielsweise vom n-Typ ist, auf der einen Hauptoberfläche mit einem großflächigen Gebiet eines zweiten Leitfähigkeitstyps, beispielsweise einem p$^+$-Gebiet versehen, durch das die nachzuweisende Strahlung einfällt. Auf der anderen Hauptoberfläche sind abwechselnd Gebiete des zweiten Leitfähigkeitstyps und Verarmungsgebiete des ersten Leitfähigkeitstyps, also beispielsweise p$^+$- und n$^+$-Gebiete vorgesehen. An den n$^+$-Gebieten liegt eine Vorspannung in Sperrichtung an.

Durch diese Anordnung ergibt sich ein bogenförmiger Verlauf des Potentialminimums für die Majoritätsträger von einem Verarmungsgebiet des ersten Leitfähigkeitstyps zum nächsten. Hierdurch werden die Driftzeiten der Elektronen wesentlich herab- und damit die möglichen Zählraten heraufgesetzt.

Ferner hat diese Anordnung den Vorteil, daß die Photolithographie bei der Herstellung wesentlich vereinfacht wird, da keine genaue Justierung der Masken für die Vorder- und Rückseite erforderlich ist.

Eine besonders einfache Ausführung der Erfindung ist im Anspruch 2 gekennzeichnet: Spannungen werden nur an (einige ausgewählte) Gebiete des zweiten Leitfähigkeitstyps einer Hauptoberfläche sowie an die auf der gleichen Hauptoberfläche vorgesehenen Zonen des ersten Leitfähigkeitstyps angelegt. Die Gebiete des zweiten Leitfähigkeitstyps auf der gegenüberliegenden Hauptoberfläche sowie die gegebenenfalls auf der Hauptoberfläche, in der die angeschlossenen Gebiete vorgesehen sind, vorhandenen weiteren Gebiete des zweiten Leitfähigkeitstyps stellen sich von selbst auf Potentiale zwischen dem Potential, auf dem die Zonen des ersten Leitfähigkeitstyps liegen, und dem Potential ein, auf dem die angeschlossenen Gebiete des zweiten Leitfähigkeitstyps liegen. Dabei berührt das Potentialminimum bzw. das Potentialtal nahezu die nicht angeschlossenen Hauptoberfläche.

Damit können alle Kontaktierungsmaßnahmen an einer Hauptoberfläche entfallen, so daß man einen einfach herzustellenden Detektor auch dann erhält, wenn in beiden Hauptoberflächen eine Vielzahl von Gebieten des zweiten Leitfähigkeitstyps vorgesehen sind. Darüberhinaus wird der einfallende Teilchenstrom nicht durch Kontakte etc beeinflußt.

Weiterbildungen der Erfindung sind in den Unteransprüchen angegeben.

Durch eine Vielzahl von Gebieten des zweiten Leitfähigkeitstyps zwischen den Gebieten des ersten Leitfähigkeitstyps, von denen nur an jeweils eines eine Spannung angelegt ist, lassen sich die verwendbaren Spannungen weiter erhöhen, da durch den Spannungsabfall an den einzelnen Gebieten des zweiten Leitfähigkeitstyps die Durchbruchspannung auch bei großen angelegten Spannung nicht erreicht wird (Anspruch 6). Einen ähnlichen Effekt erreicht man durch großflächige Gebiete mit einem hohen Widerstand (Anspruch 11).

Besonders vorteilhaft ist es, wenn gemäß Anspruch 7 auf der einen Hauptoberfläche ein großflächiges Gebiet (im Vergleich zu den Gebieten auf der anderen Hauptoberfläche) des zweiten Leitfähigkeitstyps vorgesehen ist, an das keine Spannung angelegt ist, wobei die Vorspannung an den Gebieten des ersten Leitfähigkeitstyps in der anderen Hauptoberfläche größer als der zweifache Wert der Depletationsspannung des Halbleiter ist.

### Kuze Beschreibung der Zeichnung

Die Erfindung wird nachstehend anhand von Ausführungsbeispielen unter Bezugnahme auf die Zeichnung näher beschrieben, in der zeigen :

Fig. 1 einen Querschnitt durch ein erstes Ausführungsbeispiel der Erfindung,

Fig. 2 einen Querschnitt durch ein zweites Ausführungsbeispiel der Erfindung.

Fig. 3 einen Querschnitt durch ein drittes Ausführungsbeispiel der Erfindung.

Fig. 4 einen Querschnitt durch ein viertes Ausführungsbeispiel der Erfindung,

Fig. 5 einen Querschnitt durch ein fünftes Ausführungsbeispiel der Erfindung,

Fig. 6-9 mögliche Anordnungen der $n^+$ und $p^+$-Gebiete, und

Fig. 10 eine Spannungs/Kapazitätskennlinie für ein tatsächlich realisiertes Element.

Wege zur Realisierung der Erfindung

In den folgenden Figuren sind gleiche Elemente immer mit den selben Bezugszeichen versehen, so daß bei der Vorstellung der einzelnen Figuren auf die nochmalige Beschreibung bereits· beschriebener Elemente verzichtet wird.

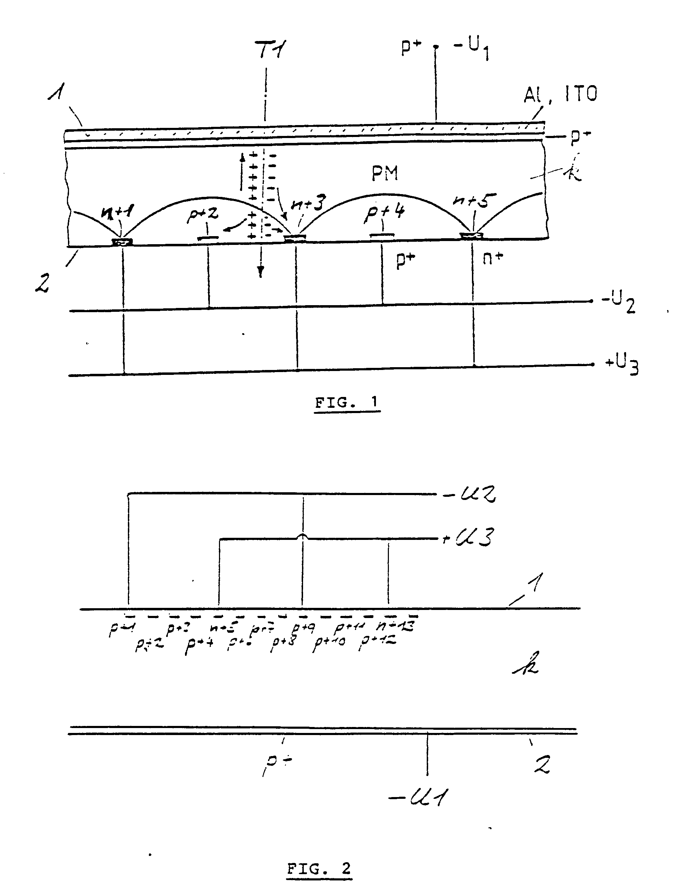

Fig. 1 zeigt einen Querschnitt durch ein erstes Ausführungsbeispiel der Erfindung, das einen Halbleiterkörper k aus n-leitendem Silizium mit zwei Hauptoberflächen 1 und 2 aufweist. In der Hauptoberfläche 2 befinden sich eine Vielzahl von voneinander getrennten Gebieten, die abwechselnd $p^+$-Gebiete $p + 2$, $p + 4$, ... und $n^+$-Gebiete $n + 1$, $n + 3$, ... sind. In der Hauptoberfläche 1 ist eine großflächige $p^+$-Schicht $p^+$ mit einer Elektrode aus Aluminium oder ITO eingebracht.

Legt man an die $p^+$-Gebiete $p + 2$, $p + 4$, ... eine Spannung - U2, an die $n^+$-Gebiete $n + 1$, $n + 3$, ... eine Spannung U3 und an das großflächige $p^+$-Gebiet in der Hauptoberfläche 1 eine Spannung - U1 an, die jeweils so groß sind, daß sich die Raumladungszonen berühren, so ergibt sich der in Fig. 1 dargestellte Verlauf für das Potentialminimum PM für die Elektronen. Das Potentialminimum verläuft dabei nicht parallel zu einer Hauptoberfläche des Halbleiterkörpers k, sondern bogenförmig von einem $n^+$-Gebiet zum nächsten. Der minimale Abstand des Potentialminimums PM von der Hauptoberfläche 2 ist dabei von den Spannungsverhältnis U1/U2 abhängig.

Ein durch die Hauptoberfläche 1 einfallendes Teilchen T1 bzw Strahlung erzeugt in bekannter Weise Elektron/Loch-Paare. Die erzeugten Elektronen werden im Potentialminimum PM gesammelt und laufen in diesem zu den $n^+$-Gebieten, während die Löcher jeweils zu den $p^+$-Gebieten auf der Hauptoberfläche 1 bzw. auf der Hauptoberfläche 2 wandern.

Dabei können sowohl das Elektronen- als auch die beiden Löchersignale als Informationsquellen für Energie, Position und/oder Reichweite der Strahlung benutzt werden. Ferner können die Teilchen durch die Hauptoberfläche 1 oder durch die Hauptoberfläche 2 einfallen.

Fig. 2 zeigt einen Querschnitt durch ein zweites Ausführungsbeispiel der Erfindung. Bei diesen Ausführungsbeispiel befinden sich zwischen den einzelnen $n^-$-Gebieten $n + 5$, $n + 13$, ... mehrere $p^+$-Gebiete $p + 1$, ..., $p + 4$, $p + 6$, ..., $p + 12$, ...

Von diesen $p^+$-Gebieten ist nur das mittlere an die Spannung - U2 angeschlossen, so daß die $p^+$-Gebiete auf unterschiedlichen Potentialen liegen. Hierdurch kann die Durchbruchspannung erhöht werden. Die Potentialstreifen bzw. Potentialringe, die auf niedrigerem Potential liegen, dienen gleichzeitig zur Erzeugung eines transversalen Driftfeldes, durch das die Elektronen im Potentialminimum PM rasch zu den $n^+$-Gebieten abfließen.

Die Zahl der zwischen die einzelnen $n^+$-Gebiete eingeschobenen $p^+$-Gebiete ist dabei von der Durchbruchspannung des jeweiligen Grundkörpers k abhängig. Der Spannungsabfall an jedem einzelnen Gebiet, der kleiner als die Durchbruchspannung sein muß, ist eine Funktion des Verhältnisses (Abstand d der einzelnen Gebiete/Breite b der einzelnen Gebiete).

Bei den in Verbindung mit den Figuren 1 und 2 beschreibenden Ausführungsbeispielen sind auf beiden Hauptoberflächen Elektroden vorgesehen, an denen Spannungen angelegt sind.

Im folgenden werden Ausführungsbeispiele beschrieben, bei denen an eine Hauptoberfläche keine Spannung angelegt ist, so daß diese Hauptoberfläche auch nicht kontaktiert werden muß.

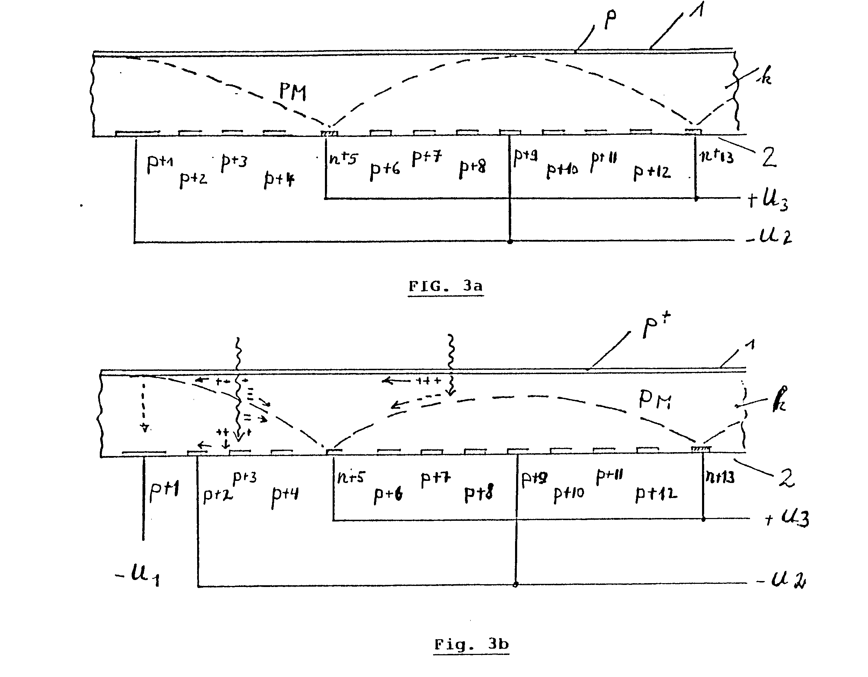

Fig. 3a zeigt einen Querschnitt durch ein drittes Ausführungsbeispiel der Erfindung, das einen Halbleiterkörper k aus n-leitendem Silizium mit zwei Hauptoberflächen 1 und 2 aufweist. In der Hauptoberfläche 2 befinden sich eine Vielzahl von voneinander getrennten $p^+$-Gebieten $p + 1$, $p + 2$, $p + 3$, ... und $n^+$-Gebieten $n + 5$, $n + 13$, ... In der Hauptoberfläche 1 ist eine großflächige Schicht $p^+$ eingebracht, die nicht kontaktiert ist, und einen niedrigen Flächenwiderstand aufweist.

Legt man zwischen den ausgewählten $p^+$-Gebiete $p + 1$, $p + 9$, ... und den $n^+$-Gebieten $n + 5$, $n + 13$, ... eine genügend hohe Spannungsdifferenz in Sperrichtung an, so stellt sich im Halbleiterkörper ein Potentialminimum bzw. ein Potential PM für die Elektronen ein, das fast die Hauptoberfläche 1 berührt. Das Potentialminimum verläuft dabei nicht parallel zu einer Hauptoberfläche des Halbleiterkörpers k, sondern bogenförmig von einem $n^+$-Gebiet zum nächsten.

Die nicht angeschlossenen $p^+$-Gebiete $p + 2$, $p + 3$, $p + 4$, $p + 6$, ... $p + 8$, $p + 10$ ... auf der Hauptoberläche 2 dienen zur Erzeugung eines geeigneten Potentialgradienten im Potentialtal. Dies ist möglich durch geeignete Wahl der Breite dieser Gebiete und des Abstandes zwischen ihnen. Die sich einstellende Spannungsdifferenz zwischen benachbarten, nicht angeschlossenen $p^+$-Gebieten ist in erster Linie von deren Abstand und der Dotierung des Grundkörpers abhängig. Die Breite der Gebiete erlaubt eine weitere Beeinflußung der elektrischen Feldstärke im Potentialtal. Die maximale Anzahl von nicht angeschlossenen $p^+$-Gebieten wird durch die Bedingung gegeben, daß das Potentialtal die Hauptoberfläche erst in den angeschlossenen $n^+$-Gebieten errei-chen darf.

Ein durch die Hauptoberfläche 1 einfallendes Teilchen bzw. Strahlung erzeugt in bekannter Weise Elektron/Loch-Paare. Die erzeugten Elektronen werden im Potentialminimum PM gesammelt und laufen in diesem zu den $n^+$-Gebieten, während die Löcher jeweils zu den $p^+$-Gebieten auf der Hauptoberfläche 1 bzw. auf der Hauptoberfläche 2 wandern.

Von der Hauptoberfläche 1 wandern die Löcher an der oder den Stellen, an denen das Potentialminimum die Fläche gerade berührt, zu den gegenüberliegenden an - U2 angeschlossenen $p^+$-Gebieten. Die in den nicht angeschlossenen $p^+$-Gebiete der Hauptoberfläche 2 gesammelten Löcher wandern nahe der Oberfläche zu dem nächsten angeschlossenen $p^+$-Gebiet.

Eine entsprechende Wahl der Anzahl sowie des Abstandes d und der Breite b der nicht angeschlossenen $p^+$-Gebiete läßt eine Optimierung der Ladungssammlungszeit gegen die Kapazität des Detektors zu. Bei großem Abstand der $n^+$-Gebiete erhält man eine kleine Kapazität, andererseits natürlich eine vergleichsweise große La-dungssammlungszeit des Detektors und umge-kehrt.

Dabei können in sehr vorteilhafter Weise sowohl das Elektronen- als auch die beiden Löchersignale als Informationsquellen benutzt werden. Dies ist an einem modifizierten Ausführungsbeispiel in Fig. 3b veranschaulicht, bei dem im Gegensatz zu Fig. 3a das p + 1-Gebiet eine von den übrigen angeschlossenen $p^+$-Gebieten getrennte Spannungsversorgung - U1 aufweist. Bei geeigneter Größe der Spannungen - U1 und - U2 läßt sich erreichen, daß das Potentialtal lediglich an der dem angeschlossenen p + 1 Gebiet gegenüberliegenden Stelle die Hauptoberfläche 1 berührt. Die zur Hauptoberfläche fließenden Löcher können also nur an dieser Stelle aus der Hauptoberfläche 1 austreten und zur p + 1-Elektrode wandern. Somit ist es also möglich, Strahlung kurzer Reichweite von solcher langer Reichweite zu unterscheiden. Strahlung kurzer Reichweite, die durch die Hauptoberfläche 1 eintritt und zwischen Hauptoberfläche 1 und dem PM absorbiert wird, liefert lediglich ein Löchersignal an der Hauptoberfläche 1 und damit am p + 1-Gebiet. Strahlung langer Reichweite erzeugt auch Löcher zwischen dem Potentialminimum und der Hauptoberfläche 2. Da letztere zu den angeschlossenen $p^+$-Gebieten in der Hauptoberfläche 2 laufen, liefern sie ein zweites Löchersignal. Strahlung kurzer und langer Reichweite läßt sich ganz einfach dadurch unterscheiden, daß entweder lediglich 1 Löchersignal an p + 1 registriert wird oder zwei Löchersignale an p + 1 und den anderen angeschlossenen $p^+$-Gebieten. Bei Eintritt der Strahlung durch die Hauptoberfläche 2 gilt sinngemäß das Gleiche.

Die in Fig. 3 gezeigte Halbleiteranordnung hat gegenüber den Halbleiterdetektoren bzw. deren Betriebsart, die in Verbindung nit den Figuren 1 und 2 beschrieben worden sind, verschiedene Vorteile :

1. Es ist keine Kontaktierung der Hauptoberfläche erforderlich. Damit kann die Halbleiteranordnung nicht nur direkt angrenzend an eine Meßanordnung angeordnet werden, durch den Fall einer Elektrode auf der Hauptoberfläche 1 wird zusätzlich auch die Nachweisempfindlichkeit für durch diese Hauptoberfläche einfallende Strahlung erhöht. Zudem verringert sich der Herstellungsaufwand.

2. Zwischen der von dem großflächigen Gebiet $p^+$ und den Halbleiterkörper k gebildeten Diode und dem angrenzenden, nicht depletierten Halbleiterkörper k stellt sich nur eine sehr kleine (oder auch keine) Spannungsdifferenz in den Randzonen der Anordnung ein. Hierdurch ist es unter Ümständen möglich, das großflächige Gebiet $p^+$ großflächig ohne Photolithographie zu implantieren.

3. Weiterhin ist die Kapazität der Anordnung kleiner als die bereits geringe Kapazität der Anordnungen mit angeschlossener Hauptoberfläche 1 da sich die Gesamtkapazität als Serienschaltung der (kleinen) Kapazität zwischen $n^+$-Gebieten und Hauptoberfläche 1 und der Kapazität zwischen angeschlossener $p^+$-Gebieten und Hauptoberfläche 1 ergibt.

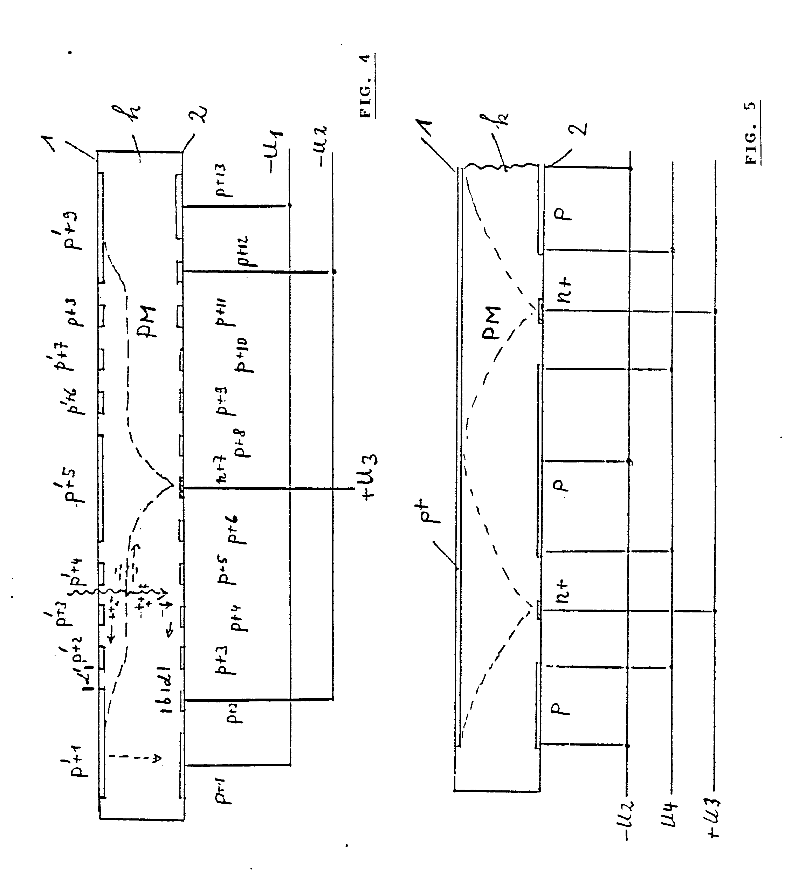

Fig. 4 zeigt ein viertes Ausführungsbeispiel der Erfindung. Bei diesem Ausführungsbeispiel ist anstelle eines großflächigen Gebietes p + mit niedrigem Flächenwiderstand eine Vielzahl von Gebieten p' + 1, p' + 2, p' + 3, ... in der Hauptoberfläche 1 vorgesehen. Das dem Gebiet p' + 1 in der Hauptoberfäche 2 gegenüberliegende Gebiet p' + 1 hat eine größere Breite b als das Gebiet p + 1. Aufgrund der Vielzahl von in der Hauptoberfläche 1 vorgesehenen Gebieten p' + ... kann die Differenz der Spannungen - U2 und + U3 größer als bei dem in Fig.1 dargestellten Ausführungsbeispiel sein, da die Gebiete p' + 2, p'3, ... die Funktion eines Spannungsteilers aufweisen.

Damit läßt sich erreichen, daß das PM aus dem p' + 1 Gebiet in den Halbleiterkörper k gedrückt wird und in einer definierten Tiefe parallel zu den Hauptoberflächen verläuft und erst kurz vor dem nächsten angeschlossenen $n^+$-Gebiet zu diesem hin abbiegt. Aufgrund der Potentialdifferenzen an den $p^+$-Gebieten in der Hauptoberfläche 1 und 2 wird ein transversales Driftfeld erzeugt, so daß Elektronen, die an irgend einer Stelle durch einfallende Strahlung gebildet werden und in das Potentialtal wandern, in diesem Tal weiter zu den $n^+$-Gebieten driften. Entsprechend verhalten sich die Löcher, wobei die zur Hauptoberfläche 1 laufenden Löcher in das p' + 1-Gebiet und von dort zu dem p + 1-Gebiet gelangen. Die zur Hauptoberfläche 2 wandernden Löcher dagegen laufen zu dem nächsten angeschlossenen $p^+$-Gebiet. Versieht man die Gebiete p + 1 und p + 2 mit getrennten Spannungsversorgungen, so lassen sich wie in Fig. 3b beschrieben die beiden Löchersignale wieder getrennt auslesen, so daß die Diskriminination Strahlung unterschiedlicher Reichweite wiederum möglich ist. Während das Ausführungsbeispiel nach Fig. 3b den Vorteil aufweist daß in der Hauptoberfläche 1 lediglich ein großflächiges p⁺-Gebiet vorgesehen ist, liegt der Vorteil des Ausführungsbeispiels nach Fig. 4 darin, daß durch den oberflächenparallelen Verlauf des Potentialminimums über eine größere Distanz eine exakte Diskrimination der Strahlung möglich ist. Ein weiterer Vorteil ist, daß der Einfallsort der Strahlung über die Driftzeit der Elektronen bestimmt werden kann. Ein solcher Strahlungsdetektor erlaubt damit folgende gleichzeitige Messungen : Bestimmung der Energie der Strahlung, Bestimmung des Einfallsortes und Diskrimination von Strahlung verschiedener Reichweite. Weiterhin ist die Kapazität dieser Anordnung kleiner, da die Entfernungen zwischen den angeschlossenen p⁺- und n⁺-Gebieten größer sind. Zusätzlich besteht die Möglichkeit die zu den p⁺-Gebieten laufenden Löcher kapazitiv auszulesen, so daß eine weitere Ortsinformation erhalten werden kann. Wird das p +2 -Gebiet nicht an eine externe Spannung angeschlossen, so wandern die Löcher von beiden Hauptoberflächen in das p + 1-Gebiet.

Fig. 5 zeigt ein fünftes Ausführungsbeispiel der Erfindung. Bei diesem Beispiel sind in der Hauptoberfläche 2 großflächige p⁺-Gebiete mit einem großen Flächenwiderstand vorgesehen. An diese sind Spannungen U4 und - U2 angelegt, an die dazwischen eingeschobenen n +- Zonen Spannungen + U3. Diese Spannungen erfüllen die Beziehung

$$U3 > U4 > - U2$$

Damit stellt sich das großflächige Gebiet in der Hauptoberfläche 1 auf eine Spannung U5 ein, für die gilt :

$$U3 > U5 > - U2$$

Ein möglicher Vorteil dieser Anordnung ist, daß an die Qualität der Photolithographie bei der Herstellung der großflächigen p⁺-Gebiete keine hohen Anforderungen gestellt werden. Zu dem kann der Verlauf des PM durch die angelegten Spannungen - U2 und U4 beeinflußt werden.

Bei den vorstehend zur exemplarischen Erläuterung der Erfindung beschriebenen Ausführungsbeispielen sind der Einfachheit halber die einzelnen Gebiete in der Hauptoberfläche 2 als streifenförmige Gebiete dargestellt worden.

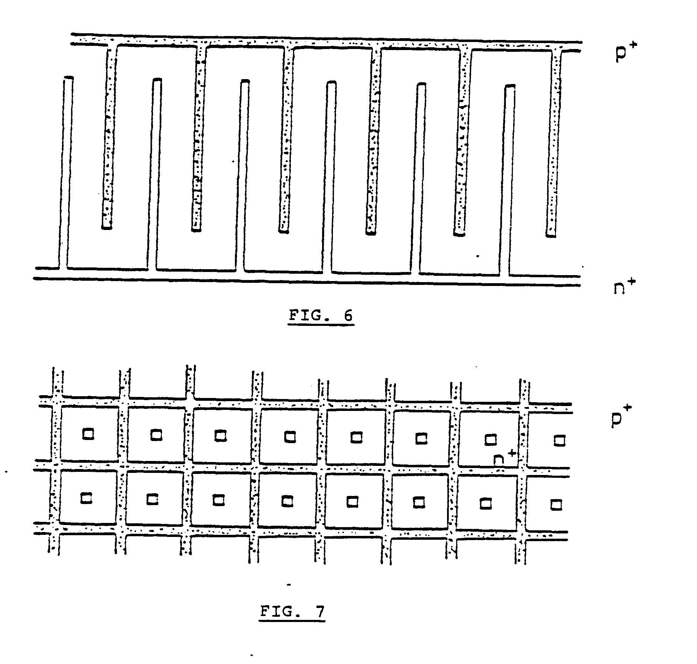

Die p⁺- und n⁺-Gebiete auf der Hauptoberfläche 2 können aber auch, wie in Fig. 6 gezeigt, kammartig angeordnet sein.

Die kammartige Anordnung vereinfacht die Kontaktierung der einzelnen Gebiete.

Ferner können auch — wie in Fig. 7 gezeigt — die n⁺-Gebiete von den p⁺- Gebieten völlig umgeben sein. Die p⁻-Gebiete können dabei — wie in Fig. 7 gezeigt — eine rechteckige Form haben, sie können aber auch wabenförmig etc. sein.

Die punktförmige Anordnung der n⁺-Gebiete bringt eine weitere Verkleinerung der Kapazität.

Außerdem kann durch ein separates Ausleses der einzelnen Gebiete eine zweidimensionale Ortsinformation erhalten werden.

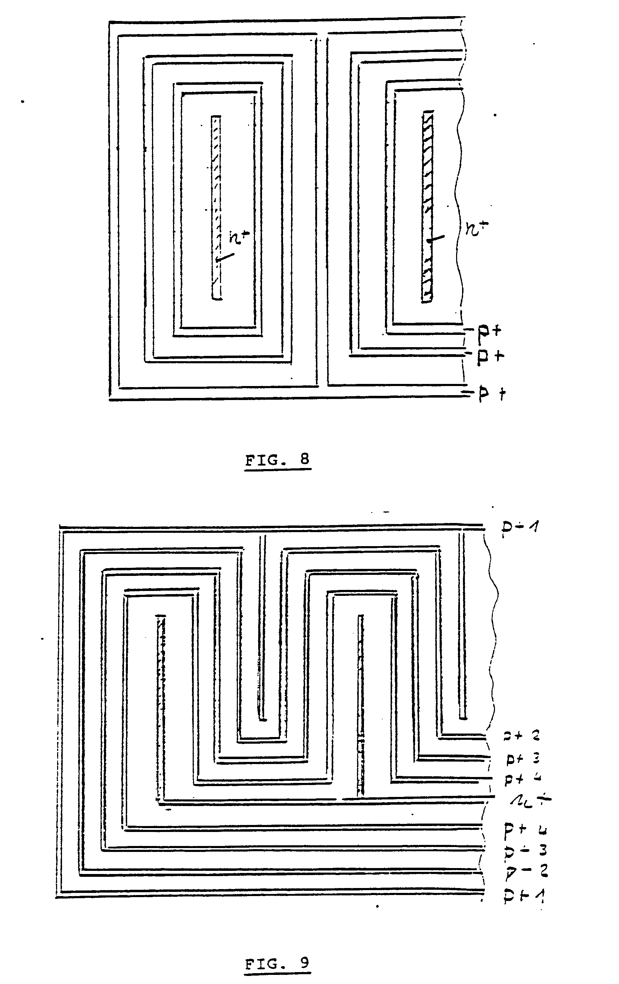

In den Fig. 8 und 9 sind weitere mögliche Geometrien der p⁺- und der n⁺-Gebiete dargestellt, bei denen die Randzonen des Detektors auf gleichem Potential liegen.

In den vorstehend beschriebenen Beispielen können selbstverständlich die in der Hauptoberfläche angeschlossenen n⁺- und p⁺-Gebiete auch mit unterschiedlichen Spannungen beaufschlagt werden. Insbesondere kann es von Vorteil sein, sowohl die einzelnen n⁺-Gebiete, als auch die p⁺-Gebiete getrennt auszulesen, so daß eine zusätzliche Ortsinformation der gemessenen Strahlung möglich ist.

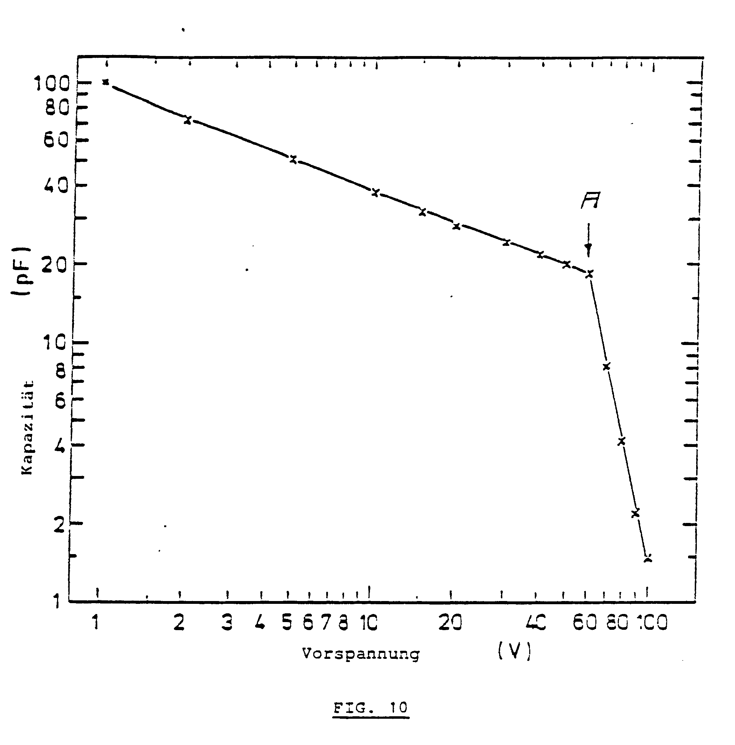

Fig. 10 zeigt die Abhängigkeit der Kapazität der großflächigen Halbleiteranordnung bzw. des Detektors von der Vorspannung, d. h. der Spannung zwischen den angeschlossenen n+ und p+- Gebieten. Der Halbleiterkörper k besteht aus einer n-Siliziumscheibe mit einer Fläche von 1 cm², der Orientierung 111 und einem spez. Widerstand von ca 4 kΩcm. Die Dicke der Scheibe beträgt ca 250 μm. Die Anordnung der p⁺ und n⁺-Gebiete auf der kontaktierten Seite entspricht der in Fig. 8 gezeigten, wobei sich zwischen einzelnen n+-Gebieten jeweils 12 p⁺-Gebiete befinden. Fig. 10 zeigt deutlich das Einsetzen der Verarmung des Halbleiterkörpers k beim Punkt A der Kennlinie

Bei der vorstehenden Beschreibung ist angenommen worden, daß der Halbleiterkörper k n-dotiert und die Gebiete des zweiten Leitfähigkeitstyps p-leitend sind. Natürliche können die p- und die n-Gebiete vertauscht werden ; außerdem können in an sich bekannter Weise anstelle von pn-Strukturen auch Oberflächen-Sperrschichten oder Schottky-Übergänge sowie heterogene Halbleiterstrukturen verwendet werden.

Schließlich ist auch die Verwendung von MIS-Kontakten (Metall-Isolator-Halbleiter-Kontakten) und insbesondere MOS-Kontakten möglich. Anstelle planarer Halbleiter sind sinngemäß auch hohle zylindrische oder kugelförmige Anordnungen realisierbar.

Ferner kann bei Anordungen, bei denen nur an eine Hauptoberfläche Spannungen angelegt werden, auf der anderen Hauptoberfläche eine Inversionsschicht bei einem aus p-Silizium bestehenden Halbleiterkörper auch dadurch erreicht werden, daß diese Hauptoberfläche einfach oxidiert wird. Inversionsschichten können bei n- und p-leitenden Halbleiterkörpern auch durch MOS-Kontakte etc erreicht werden.

## Patentansprüche

1. Halbleiterdetektor mit niedriger Kapazität zum Nachweis von Strahlung und Teilchen mit einem Halbleiterkörper eines ersten Leitfähigkeitstyps, auf dem mindestens eine Sammelelektrode für die Majoritätsträger aufgebracht ist, und Gebieten eines zweiten Leitfähigkeitstyps auf beiden Hauptoberflächen des Halbleiterkörpers, die mit dem Halbleiterkörper derart vorgespannte Sperrschichten bilden, daß der Halbleiterkörper praktisch vollständig an Majoritätsträgern verarmt und im Halbleiterkörper ein Potentialgradient vorhanden ist, durch den die von der Strahlung erzeugten Majoritätsträger zu der Sammelelektrode fließen, dadurch gekennzeichnet, daß auf einer der beiden Hauptoberflächen zwischen den Gebieten des zweiten Leitfähigkeitstyps Zonen des ersten Leitfähigkeitstyps, die gegenüber den Gebieten des zweiten Leitfähigkeitstyps in Sperrichtung vorgespannt sind und an die die Sammelelektrode angeschlossen ist, und auf der anderen Hauptoberfläche ein großflächiges Gebiet vom zweiten Leitfähigkeitstyp mit niedrigen Flächenwiderstand vorgesehen ist.

2. Halbleiterdetektor mit niedriger Kapazität zum Nachweis von Strahlung und Teilchen mit einem Halbleiterkörper eines ersten Leitfähigkeitstyps, auf dem mindestens eine Sammelelektrode für die Majoritätsträger aufgebracht ist, Gebieten eines zweiten Leitfähigkeitstyps auf beiden Hauptoberflächen des Halbleiterkörpers, die mit dem Halbleiterkörper derart vorgespannte Sperrschichten bilden, daß der Halbleiterkörper praktisch vollständig an Majoritätsträgern verarmt und im Halbleiterkörper ein Potentialgradient vorhanden ist, durch den die von der Strahlung erzeugten Majoritätsträger zu der Sammelelektrode fließen, dadurch gekennzeichnet, daß auf mindestens einer der beiden beiden Hauptoberflächen zwischen den Gebieten des zweiten Leitfähigkeitstyps Zonen vom ersten Leitfähigkeitstyp vorgesehen sind, die gegenüber den Gebieten des zweiten Leitfähigkeitstyps in Sperrichtung vorgespannt sind, und daß nur an Zonen, an die die Sammelelektrode angeschlossen ist, bzw. an Gebiete auf einer Hauptoberfläche äußere Spannungen angelegt sind.

3. Halbleiterdetektor nach Anspruch 2, dadurch gekennzeichnet, daß auf der Hauptoberfläche, an der keine äußere Spannung angelegt ist, ein großflächiges Gebiet vom zweiten Leitfähigkeitstyp mit niedrigem Flächenwiderstand vorgesehen ist.

4. Halbleiterdetektor nach einem der Ansprüche 1 bis 3, dadurch gekennzeichnet, daß die Zonen des ersten Leitfähigkeitstyps und die Gebiete des zweiten Leitfähigkeitstyps kammartig ineinander eingeschoben sind.

5. Halbleiterdetektor nach einem der Ansprüche 1 bis 4, dadurch gekennzeichnet, daß eine Vielzahl von Gebieten des ersten Leitfähigkeitstyps von mindestens einen zusammenhängenden Gebiet des zweiten Leitfähigkeitstyps umgeben ist.

6. Halbleiterdetektor nach einem der Ansprüche 1 bis 5, dadurch gekennzeichnet, daß zwischen den Gebieten vom ersten Leitfähigkeitstyp und vom zweiten Leitfähigkeitstyp, an die Spannungen angelegt sind, weitere Gebiete des zweiten Leitfähigkeitstyps eingeschoben sind, an die keine Spannungen angelegt sind.

7. Halbleiterdetektor nach einem der Ansprüche 2 bis 6, dadurch gekennzeichnet, daß auf der Hauptoberfläche, auf der keine Zonen des ersten Leitfähigkeitstyps vorgesehen sind, eine Vielzahl von Gebieten des zweiten Leitfähigkeitstyps vorgesehen ist.

8. Halbleiterdetektor nach Anspruch 7, dadurch gekennzeichnet, daß die Gebiete des zweiten Leitfähigkeitstyps, die Gebieten des zweiten Leitfähigkeitstyps gegenüberliegen, an die Spannungen angelegt sind, breiter als diese Gebiete sind.

9. Halbleiterdetektor nach Anspruch 7, dadurch gekennzeichnet, daß die Gebiete des zweiten Leitfähigkeitstyps, die den Gebieten des ersten Leitfähigkeitstyps gegenüberliegen, breiter als diese Gebiete sind.

10. Halbleiterdetektor nach einem der Ansprüche 1 bis 6, dadurch gekennzeichnet, daß auf der Hauptoberfläche, auf der Zonen des ersten Leitfähigkeitstyps vorgesehen sind, mindestens ein großflächiges Gebiet des zweiten Leitfähigkeitstyps mit einem definierten Flächenwiderstand vorgesehen ist.

11. Halbleiterdetektor nach Anspruch 10, dadurch gekennzeichnet, daß das großflächige Gebiet einen großen Flächenwiderstand hat.

12. Halbleiteranordnung nach einem der Ansprüche 1 bis 11, dadurch gekennzeichnet, daß eine Vielzahl von Gebieten des ersten und des zweiten Leitfähigkeitstyps mäanderartig ineinander eingeschoben sind.

## Claims

1. Semiconductor detector of low capacity for the detection of radiation and particles, comprising a semiconductor body of a first type of conduction on which at least one majority-carrier collector electrode is applied, as well as zones of a second type of conduction on both primary surfaces of the semiconductor body which cooperate with said body to form depletion layers so polarized that the semiconductor body is pratically completely depleted of majority carriers while in the semiconductor body a potential gradient is present which causes the majority carriers created by the radiation to flow to said collector electrode, characterized in that on one of said two primary surfaces, between the areas of the second type of conduction, zones of the first type of conduction which are polarized relative to the zones of the second type of conduction in a reverse direction and to which the said collector electrode is connected, and on the other primary surface a large-surface area of the second type of conduction and of a low surface resistance are provided.

2. Semiconductor detector of low capacity for the detection of radiation and particles, comprising a semiconductor body of a first type of conduction on which at least one majority-carrier collector electrode is applied, as well as zones of a second type of conduction on both primary surfaces of the semiconductor body which cooperate with said body to form depletion layers so polarized that the semiconductor body is prati

cally completely depleted of majority carriers while in the semiconductor body a potential gradient is present which causes the majority carriers created by the radiation to flow to said collector electrode, characterized in that at least on one of said two primary surfaces, between the areas of the second type of conduction, zones of the first type of conduction are provided which are polarized relative to the zones of the second type of conduction in a reverse direction, and that external voltages are applied only to zones to which the said collector electrode is connected, or to zones on one of said primary surfaces, respectively.

3. Semiconductor detector according to Claim 2, characterized in that a large-surface area of the second type of conduction at a low surface resistance is provided on that primary surface at which an external voltage is not applied.

4. Semiconductor detector according to any of Claims 1 through 3, characterized in that the zones of said first type of conduction and the areas of said second type of conduction are interlocked with each other in a comb-like structure.

5. Semiconductor detector according to any of Claims 1 through 4, characterized in that a plurality of zones of said first type of conduction is surrounded by at least one coherent area of said second type of conduction.

6. Semiconductor detector according to any of Claims 1 through 5, characterized in that further areas of said second type of conduction, to which no voltage is applied, are interposed between the areas of said first type of conduction and of said second type of conduction, to which voltages are applied.

7. Semiconductor detector according to any of Claims 2 through 6, characterized in that on that primary surface where there are no zones of said first type of conduction, a plurality of areas of said second type of conduction is provided.

8. Semiconductor detector according to Claim 7, characterized in that the areas of said second type of conduction which are opposite to areas of said second type of conduction to which voltages are applied are wider than the latter areas.

9. Semiconductor detector according to Claim 7, characterized in that the areas of said second type of conduction which are opposite to the areas of said first type of conduction are wider than the latter areas.

10. Semiconductor detector according to any of Claims 1 through 6, characterized in that at least one large-surface area of said second type of conduction having a defined surface resistance is provided on the primary surface where the zones of said first type of conduction are provided.

11. Semiconductor detector according to Claim 10, characterized in that said large-surface area has a high surface resistance.

12. Semiconductor system according to any of Claims 1 through 11, characterized in that a plurality of areas of said first and of said second type of conduction are mutually interlocked in a meandering arrangement.

## Revendications

1. Détecteur semiconducteur à faible capacité pour la détection d'un rayonnement et des particules, comprenant un élément semiconducteur d'un premier type de conduction sur lequel au moins une électrode de captage pour les porteurs majoritaires est disposée, ainsi que des zones d'un deuxième type de conduction sur les deux surfaces principales dudit élément semiconducteur qui coopère avec le dernier pour former des couches de jonction tellement polarisées que ledit élément semiconducteur est pratiquement totalement appauvrissé en porteurs majoritaires et qu'il y a un gradient du potentiel dans l'élément semiconducteur qui crée une migration des porteurs majoritaires produits par le rayonnement vers ladite électrode de captage, caractérisé en ce que des zones du premier type de conduction polarisées en sens de non-conduction par rapport aux zones du deuxième type de conduction, auxquelles ladite électrode de captage est raccordée, sont interposées entre les zones du deuxième type de conduction, pendant qu'une zone à grande surface du deuxième type de conduction à faible résistance en plan est pourvue sur l'autre surface principale.

2. Détecteur semiconducteur à faible capacité pour la détection d'un rayonnement et des particules, comprenant un élément semiconducteur d'un premier type de conduction sur lequel au moins une électrode de captage pour les porteurs majoritaires est disposée, et de plus comprenant des zones d'un deuxième type de conduction sur les deux surfaces principales dudit élément semiconducteur, qui coopèrent avec le dernier afin de constituer des couches de jonction tellement polarisées que ledit élément semiconducteur est pratiquement totalement appauvrissé en porteurs et qu'il y a un gradient du potentiel dans l'élément semiconducteur qui crée une migration des porteurs majoritaires produits par le rayonnement vers ladite électrode de captage, caractérisé en ce que des zones du premier type de conduction polarisées en sens de non-conduction par rapport aux zones du deuxième type de conduction, sont disposées sur au moins une desdites deux surfaces principales entre les zones du deuxième type de conduction, et que des tensions extérieures sont appliquées seulement aux zones auxquelles ladite électrode de captage est raccordée ou aux zones sur une surface principale.

3. Détecteur semiconducteur selon la Revendication 2, caractérisé en ce qu'une zone à grande surface du deuxième type de conduction de faible résistance en plan est pourvue sur celle des deux surfaces principales à laquelle une tension extérieure n'est pas appliquée.

4. Détecteur semiconducteur selon quelconque des Revendications 1 à 3, caractérisé en ce que les zones du premier type de conduction et les zones du deuxième type de conduction sont insérées les unes dans les autres en forme de crêtes.

5. Détecteur semiconducteur selon quelconque des Revendications 1 à 4, caractérisé en ce qu'une pluralité des zones du premier type de conduction est entourée par au moins une zone cohérente du deuxième type de conduction.

6. Détecteur semiconducteur selon quelconque des Revendications 1 à 5, caractérisé en ce que des zones additionnelles du deuxième type de conduction, auxquelles des tensions ne sont pas appliquées, sont interposées entre les zones du premier type de conduction et du deuxième type de conduction auxquelles des tensions sont appliquées.

7. Détecteur semiconducteur selon quelconque des Revendications 2 à 6, caractérisé en ce qu'une pluralité des zones du deuxième type de conduction est pourvue sur la surface principale qui ne comprend pas des zones du premier type de conduction.

8. Détecteur semiconducteur selon la Revendication 7, caractérisé en ce que les zones du deuxième type de conduction en face des zones du deuxième type de conduction chargées en tension ont une largeur plus grande que celle des dernières zones.

9. Détecteur semiconducteur selon la Revendication 7, caractérisé en ce que les zones du deuxième type de conduction en face du premier type de conduction ont une largeur plus grande que celle des dernières zones.

10. Détecteur semiconducteur selon quelconque des Revendications 1 à 6, caractérisé en ce qu'une zone du deuxième type de conduction à grande surface et à une résistance en plan définie est pourvue sur la surface principale comprenante des zones du premier type de conduction.

11. Détecteur semiconducteur selon la Revendication 10, caractérisé en ce que ladite zone à grande surface présente une haute résistance en plan.

12. Système semiconducteur selon quelconque des Revendications 1 à 11, caractérisé en ce que plusieurs zones du premier et du deuxième type de conduction sont insérées les unes dans les autres en méandres.

FIG. 1

FIG. 2

FIG. 3a

Fig. 3b

FIG. 4

FIG. 5

EP 0 179 828 B1

p$^+$

n$^+$

FIG. 6

p$^+$

n$^+$

FIG. 7

4

FIG. 8

FIG. 9

FIG. 10